# EUROPÄISCHE PATENTSCHRIFT

(11) **EP 3 357 132 B1**
(45) Veröffentlichungstag und Bekanntmachung des Hinweises auf die Patenterteilung: **14.08.2019**
(21) Anmeldenummer: 16770266.1
(22) Anmeldetag: 22.09.2016
(51) Int. Cl.: H01S 5/022, H01S 5/40, H01S 5/028, H01S 5/14, H01S 5/50, G02B 6/42

(54) **HALBLEITERLICHTQUELLE UND VERFAHREN ZUR HERSTELLUNG EINER HALBLEITERLICHTQUELLE**
SEMICONDUCTOR LIGHT SOURCE AND METHOD FOR FABRICATING A SEMICONDUCTOR LIGHT SOURCE
SOURCE SEMI-CONDUCTRICE ET PROCÉDÉ DE FABRICATION D'UNE SOURCE À SEMI-CONDUCTEUR

(30) Priorität: 01.10.2015 DE 102015219056
(43) Veröffentlichungstag der Anmeldung: 08.08.2018
(73) Patentinhaber: Fraunhofer-Gesellschaft zur Förderung der angewandten Forschung e.V., 80686 München (DE)
(72) Erfinder: MÖHRLE, Martin, 12683 Berlin (DE); THEURER, Michael, 10245 Berlin (DE); SIGMUND, Ariane, 10243 Berlin (DE); TROPPENZ, Ute, 12524 Berlin (DE)
(74) Vertreter: Zimmermann, Tankred Klaus
(86) Internationale Anmeldenummer: PCT/EP2016/072519
(87) Internationale Veröffentlichungsnummer: WO 2017/055162

(56) Entgegenhaltungen:
- EP-A2- 0 798 576
- JP-A- 2000 124 539
- US-A1- 2002 001 326
- US-A1- 2009 130 830
- LEONTIOS STAMPOULIDIS ET AL: "The BOOM project: a new generation of photonic routing subsystems using hybrid integration on silicon-on-insulator waveguide boards", OPTICAL SENSING II, Bd. 7719, 30. April 2010 (2010-04-30), Seite 771909, XP055327431, 1000 20th St. Bellingham WA 98225-6705 USA ISSN: 0277-786X, DOI: 10.1117/12.855958 ISBN: 978-1-62841-971-9 in der Anmeldung erwähnt

## Beschreibung

Die vorliegende Erfindung bezieht sich auf ein Verfahren zur Herstellung einer Halbleiterlichtquelle sowie auf eine Halbleiterlichtquelle, die mit dem beschriebenen Verfahren hergestellt werden kann. Ausführungsbeispiele zeigen BH-Laserarrays (buried heterostructure laser arrays) und SOA-Arrays (semiconductor optical amplifier arrays) mit neuartigen vertikalen Auflageflächen, Monitorkontakten und horizontalen Justiermarken zur präzisen XYZ-Justage bei Flip-Chip-Montage.

Die Silizium-Photonik ist in den letzten Jahren aus dem Forschungsstadium herausgetreten und dabei, sich im Markt zu etablieren. Die Vorteile der Siliziumtechnologie liegen darin, dass optische und elektronische Funktionen in einem Massenprozess kompakt, energieeffizient und kostengünstig monolithisch integriert werden können. Allerdings fehlt dieser Integrationsplattform eine Lichtquelle.

Hauptsächlich werden hier bislang InP-basierende Laser- oder Halbleiterverstärker (SOA, semiconductor optical amplifier) als Einzelchips oder in Array-Anordnung eingesetzt, die in Flip-Chip-Montage mit sogenannter Butt-Joint-Kopplung an Si-Wellenleiter angekoppelt werden können. Alternativ können auch vertikal emittierende Laser (VCSEL: vertical cavity surface emitting laser, HCSEL: horizontal cavity surface emitting laser) eingesetzt werden, die über Si-Gitterkoppler in Si-Wellenleiter eingekoppelt werden.

In beiden Fällen ist eine präzise XYZ-Justage der Laserkomponenten im sub-µm Bereich erforderlich, um eine effiziente Lichteinkopplung zu gewährleisten.

Hierzu wurden in den vergangenen Jahren viele Untersuchungen durchgeführt. In den bekannten Fällen [1]...[7] wurden mittels Trockenätztechnik auf den Laserkomponenten Auflageflächen definiert, die dann als Aufstandsflächen bei der Flip-Chip-Montage fungieren. Die Genauigkeit dieser vertikalen Z-Justierung hängt jedoch direkt von der Genauigkeit der mittels Trockenätzen zu realisierenden Ätztiefe ab. In Laserrichtung (X) wird üblicherweise auf Stoß gekoppelt, senkrecht zur Laserrichtung werden horizontale Anschläge verwendet, oder es wird anhand von speziell auf den Laserkomponenten angebrachten Justiermarken justiert [1]...[7].

Diese bisher bekannte Vorgehensweise hat jedoch einige erhebliche Nachteile:
- Mittels Trockenätzen hergestellte vertikale Aufstandsflächen sind nicht präzise genug
- Horizontale/seitliche Anschläge sind bei schräg gestellten Laserstreifen (Bsp. SOA) aufgrund der begrenzten Spaltgenauigkeit der Laser nicht verwendbar
- die Positionsgenauigkeit von realisierten Justiermarken auf Laserkomponenten hängt direkt von der Lithographiegenauigkeit ab und ist für eine präzise Justage nicht ausreichend.

Die US 2009/0130830 A1 beschreibt ein Verfahren zur Herstellung eines optischen Halbleiterelements. Um einen aktiven Bereich, in dem die eigentliche Lichtquelle erzeugt wird, sind Ausrichtungsmarkierungen vorgesehen, die durch die Strukturierung der Schichtfolge zur Erzeugung der aktiven Lichtquelle definiert werden.

Die EP 0 798 576 A2 beschreibt die Verwendung von Justiermarken parallel zu aktiven Bereichen, wobei die aktiven Bereiche mit einer Deckschicht bedeckt sind, und die Justiermarke freigelegt ist.

Weitere Beispiele für optische Elemente werden in der JP 2000/124539 A, in der US 2002/001326 A1) und von LEONTIOS STAMPOULIDIS ET AL, "The BOOM project: a new generation of photonic routing subsystems using hybrid integration on silicon-on-insulator waveguide boards", OPTICAL SENSING II, 1000 20th St. Bellingham WA 98225-6705 USA, (20100430), vol. 7719, doi:10.1117/12.855958, ISSN 0277-786X, ISBN 978-1-62841-971-9, beschrieben.

Der vorliegenden Erfindung liegt somit die Aufgabe zugrunde, ein verbessertes Konzept zur Justierung von Halbleiterlichtquellen mit einer Vorrichtung zur Aufnahme der Halbleiterlichtquelle zu schaffen.

Diese Aufgabe wird durch den Gegenstand der unabhängigen Patentansprüche gelöst. Erfindungsgemäße Weiterbildungen sind in den Unteransprüchen definiert.

Der vorliegenden Erfindung liegt die Idee zugrunde, Justierungsmarken auf bzw. in Halbleiterlichtquellen zu schaffen, die eine hochpräzise XYZ-Justierung der Halbleiterlichtquelle in bzw. mit einer Vorrichtung zur Aufnahme der Halbleiterlichtquelle, z.B. ein Substrat eines Halbleiterchips, ermöglicht, die die Gegenstücke zu den Justierungsmarken in der Halbleiterlichtquelle aufweist. So kann die Halbleiterlichtquelle eine Einsparung oder Einkerbung ähnlich einer Nut aufweisen, wohingegen die Vorrichtung zur Aufnahme der Halbleiterlichtquelle die zugehörige Aussparung oder Auskerbung ähnlich einer zu der Nut passenden Feder aufweist. Die Zuordnung von Nut und Feder ist hier jedoch nur beispielhaft zu sehen und kann durch weitere Anordnungen ersetzt werden. Zur vertikalen Justierung, bzw. der Justierung in Z-Richtung, kann die Halbleiterlichtquelle, beispielsweise ein Laser oder ein optischer Verstärker (SOA) eine oder mehrere Aussparungen in der Abdeckungsschicht aufweisen, die auf der Begrenzungsschicht, z.B. einem (Licht-) Wellenleiter enden, wobei der Wellenleiter in diesem Bereich der Halbleiterlichtquelle vorteilhafterweise inaktiv ist. In anderen Worten liegen die vertikalen Justierungsmarken vorteilhafterweise außerhalb, d.h. nicht oberhalb, der lichtemittierenden Streifen. Das Entfernen der genannten Bereiche kann selektiv erfolgen, so dass hochpräzise auf die Begrenzungsschicht geätzt werden kann. Somit entsteht eine (in ihrer Höhe) genau definierte Auflagefläche bzw. vertikale Justierungsmarke, die unabhängig von Ungenauigkeiten in (Trocken-) Ätzverfahren ist.

Ferner können horizontale Justierungsmarken im selben Arbeitsschritt bzw. Verfahrensschritt wie die Laserstrukturen bzw. die Licht emittierenden Streifen in die Schichtfolge geformt bzw. geätzt werden. Durch das parallele bzw. zeitgleiche Erzeugen der horizontalen Justierungsmarke mit den Laserstrukturen werden kleinste Ungenauigkeiten bei der Erzeugung der Laserstrukturen auch auf die Justierungsmarke übertragen, wodurch die Ausrichtung der Halbleiterlichtquelle ohne die genannten Fertigungstoleranzen erfolgen kann.

Ferner ist es vorteilhaft, die vertikalen Justierungsmarken, d.h. die Auflageflächen auf dem Lichtwellenleiter, abseits der Lichtein- bzw. Lichtaustrittskante der Halbleiterlichtquelle anzuordnen. Somit wird gewährleistet, dass sich eine Beschichtung der Facetten an der Lichtein- bzw. Lichtaustrittskante nicht auf die vertikale Justierungsmarke auswirkt, indem sich das Beschichtungsmaterial für die Facettenbeschichtung nicht an bzw. auf der vertikalen Justierungsmarke ablagert. Somit ist eine exakte Positionierung möglich, die keinen Offset bzw. einen Versatz in Höhe der Schichtdicke aufweist, der im Falle einer Ablagerung des Beschichtungsmaterials auf der Justierungsmarke unweigerlich entsteht.

Gemäß weiteren Ausführungsbeispielen weist das Verfahren das Anordnen von zumindest einem freiliegenden Kontakt oberhalb der Schichtfolge auf, wobei der Kontakt eine elektrische Justiermarke formt. Zur elektrischen Kontaktierung ist es vorteilhaft, an der Halbleiterlichtquelle einen weiteren Kontakt anzuordnen, der einen Stromfluss von der Vorrichtung, die die Halbleiterlichtquelle aufnimmt, durch die Halbleiterlichtquelle ermöglicht. Ein alternatives Ausführungsbeispiel zeigt einen Verfahrensschritt zum Formen der elektrischen Justiermarke mit Anordnen von zumindest zwei freiliegenden Kontakten, wobei einer (oder mehrere) der zumindest zwei freiliegenden Kontakte oberhalb der Schichtfolge angeordnet ist. Mittels der elektrischen Kontakte kann eine rein elektrische und somit leicht automatisierbare Überprüfung vorgenommen werden, ob die Halbleiterlichtquelle an der vorgesehenen Position innerhalb der Halbleitervorrichtung angeordnet ist. Somit kann z.B. ein Halbleiterlaser oder ein optischer Verstärker in einen Siliziumchip oder allgemein, einen Halbleiterchip eingesetzt werden, wobei der Halbleiterchip ebenfalls Kontakte als Gegenstück zu den Kontakten der Halbleiterlichtquelle aufweist und beispielsweise mittels einer bekannten angelegten Spannung und der daraus resultierenden Stromstärke überprüfen kann, ob die Kontakte in der Halbleiterlichtquelle die Kontakte im Chip kontaktieren. Ist die Halbleiterlichtquelle z.B. verkantet oder schräg in dem Chip angeordnet, erfolgt keine oder zumindest nur eine lose oder schlechte Kontaktierung mit erhöhtem Übergangs- oder Kontaktwiderstand der gegenüberliegenden Kontakte, woraus ein geringerer Stromfluss bei bekannter angelegter Spannung (oder umgekehrt) resultiert. Um eine z.B. definierte Kontaktfläche bzw. eine bessere Kontaktierung der gegenüberliegenden Kontakte des Chips sowie der Halbleiterlichtquelle zu ermöglichen, kann eine Metallisierungsschicht auf die Kontakte aufgetragen (z.B. aufgedampft) werden. Die Kontakte können mit einer derart geringen Höhe auf der Abdeckungsschicht aufgebracht werden, so dass die exakte Positionierung der Halbleiterlichtquelle durch die Kontakte nicht beeinträchtigt wird.

Ferner wird durch das Formen der lateralen Justiermarken, die gemäß Ausführungsbeispielen auch in der Facettenansicht, d.h. aus einer Aufsicht auf die Lichtein- bzw. Lichtaustrittskante sichtbar sind, eine 3-dimensionale Informationserfassung möglich. Dies ist vorteilhaft, da (Kamera-basierte) Handlingsysteme, die beispielsweise die Halbleiterlichtquelle in den Chip einsetzen, eine Orientierung der Halbleiterlichtquelle aus einer beliebigen Position erkennen können, ohne dass die Halbleiterlichtquelle dafür in eine bestimmte Position zur Kamera gedreht wird.

Bevorzugte Ausführungsbeispiele der vorliegenden Anmeldung werden nachfolgend Bezug nehmend auf die beiliegenden Zeichnungen mehr erläutert. Es zeigen:
- Fig. 1: ein Flussdiagramm eines Verfahrens zur Herstellung einer Halbleiterlichtquelle;
- Fig. 2: eine schematische Darstellung einer Halbleiterlichtquelle, die mit dem Verfahren aus Fig. 1 hergestellt ist;
- Fig. 3: zeigt ein Flussdiagramm des Verfahrens zur Herstellung einer Halbleiterlichtquelle;
- Fig. 4: zeigt einen schematischen Querschnitt einer Halbleiterlichtquelle mit vertikalen Aufstandsflächen für ein beispielhaftes SOA-Array;
- Fig. 5: zeigt eine schematische Aufsicht der Halbleiterlichtquelle mit vertikalen Aufstandsflächen für ein beispielhaftes SOA-Array, wobei eine Bedeckung dieser Aufstandsflächen durch Facettenbeschichtungsmaterial durch die eingebaute Stufe effektiv verhindert wird;
- Fig. 6: zeigt eine schematische Aufsicht der Halbleiterlichtquelle mit vertikalen Aufstandsflächen für ein beispielhaftes SOA-Array, wobei die vertikalen Aufstandsflächen hier in zwei unterschiedliche Flächen pro Seite getrennt sind;
- Fig. 7: zeigt eine schematische Aufsicht der Halbleiterlichtquelle mit horizontalen Justiermarken und vertikalen Aufstandsflächen gemäß einem Ausführungsbeispiel;
- Fig. 8: zeigt eine schematische Aufsicht der Halbleiterlichtquelle mit horizontalen Justiermarken und vertikalen Aufstandsflächen gemäß Fig. 7;
- Fig. 9: zeigt eine schematische Aufsicht der Halbleiterlichtquelle mit horizontalen Justiermarken und vertikalen Aufstandsflächen gemäß einem weiteren Ausführungsbeispiel;
- Fig. 10: zeigt eine schematische Aufsicht auf ein SOA-Array als Halbleiterlichtquelle mit vertikalen Aufstandsflächen und InP-Facetten (ohne aktive Schicht im Facettenbereich) gemäß einem Ausführungsbeispiel, wobei Fig. 10a die Anordnung der InP-Facetten über die gesamte Breite der Lichtaustrittsbzw. Lichteintrittskanten zeigt und Fig. 10b die Anordnung der InP-Facetten in einem Bereich der lichtemittierenden Streifen vorsieht;
- Fig. 11: einen schematischen Querschnitt einer Halbleitervorrichtung, die ein Substrat mit darin eingesetzter Halbleiterlichtquelle aufweist; und
- Fig. 12: eine schematische Darstellung einer Kaskade von Halbleiterlichtquellen.

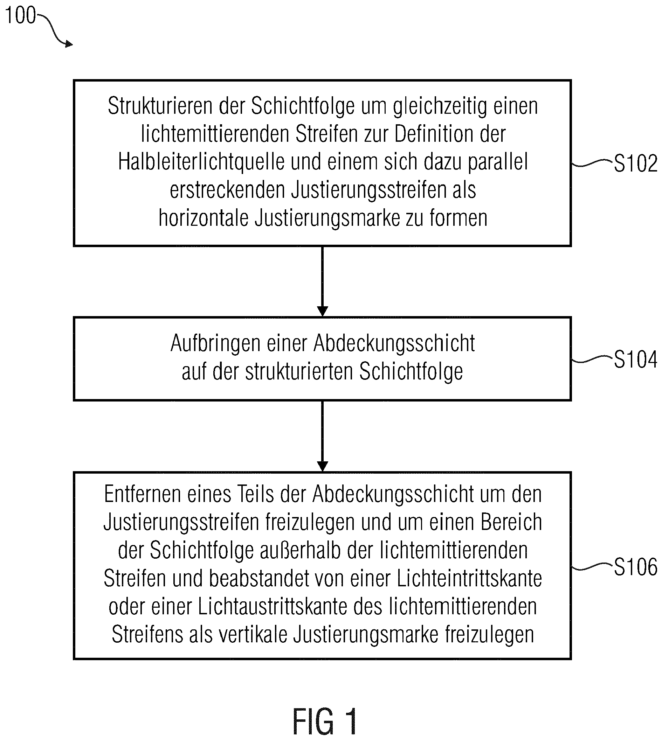

In der nachfolgenden Beschreibung der Figuren werden gleiche oder gleichwirkende Elemente mit den gleichen Bezugszeichen versehen, so dass deren Beschreibung in den unterschiedlichen Ausführungsbeispielen untereinander austauschbar ist. Die Figuren 1 bis 6 beschreiben Beispiele die zum Verständnis der Erfindung dienen.

Nachfolgend wird ein Verfahren zur Herstellung einer Halbleiterlichtquelle sowie eine mit dem Verfahren herstellbare Halbleiterlichtquelle gezeigt, die vertikale Aufstandsflächen und horizontale Justiermarken aufweist die beide unabhängig von Prozessierungstoleranzen, Spaltungenauigkeiten und Facettencoating eine präzise Justage der Laser oder SOA-Komponenten erlauben. Dies ist mit bisher bekannten Aufstandsflächen/Justiermarken nicht möglich.

Fig. 1 zeigt eine schematische Darstellung eines Verfahrens 100 zur Herstellung einer Halbleiterlichtquelle. Die Halbleiterlichtquelle weist ein Substrat sowie eine oberhalb des Substrats angeordnete Schichtfolge auf, wobei dieselbe eine lichtemittierende Schicht und eine oberhalb der lichtemittierenden Schicht angeordnete obere Begrenzungsschicht aufweist. In einem Schritt S102 wird die Schichtfolge strukturiert, um gleichzeitig einen lichtemittierenden Streifen zur Definition der Halbleiterlichtquelle und einem sich dazu parallel erstreckenden Justierungsstreifen als horizontale Justierungsmarke zu formen. In einem weiteren Schritt S104 wird eine Abdeckungsschicht auf die strukturierte Schichtfolge aufgebracht und in Schritt S106 wird ein Teil der Abdeckungsschicht entfernt, um den Justierungsstreifen freizulegen und um einen Bereich der Schichtfolge außerhalb der lichtemittierenden Streifen und beabstandet von einer Lichteintrittskante oder einer Lichtaustrittskante des lichtemittierenden Streifens als vertikale Justierungsmarke freizulegen.

Das gleichzeitige Strukturieren der Schichtfolge und der lichtemittierenden Streifen hat den Vorteil, dass die horizontalen Justierungsmarken mit derselben Genauigkeit bzw. Ungenauigkeit in die Schichtfolge geätzt bzw. geformt werden, so dass eine Position der Lichtaustrittsbereiche der Halbleiterlichtquelle relativ zu der horizontalen Justierungsmarke gleich bleibt und somit exakt definiert ist. Dies ermöglicht, in horizontaler bzw. X-Y-Ausrichtung, eine exakte Positionierung des Lichtaustrittsbereichs bzw. der Lichtaustrittsfacette auf eine optische Einheit, z.B. einen (optischen bzw. Licht-) Wellenleiter, in eine Vorrichtung zur Aufnahme der Halbleiterlichtquelle, z.B. ein Halbleitersubstrat bzw. einen Halbleiterchip. Die Schichtfolge kann eine lichtemittierende Schicht sowie einen (Licht-) Wellenleiter zur Bündelung der aus der lichtemittierenden Schicht austretenden Photonen aufweisen.

In die aktive bzw. lichtemittierende Schicht (oder Schichten) sowie in die darüber angeordnete Begrenzungsschicht, oder allgemein in die Schichtfolge, sind demnach die Strukturen für die Lichterzeugung sowie die horizontalen Justiermarken geätzt worden. Darüber wird nun die Abdeckungsschicht aufgebracht, die beispielsweise ein Cladding Layer umfasst und das Austreten des Lichts aus dem Lichtwellenleiter an einer anderen Stelle als der Lichtein- oder Lichtaustrittskante bzw. der Facetten verhindert. Der Cladding-Layer ist in den gezeigten Abbildungen gemäß Ausführungsbeispielen p-dotiert und kann an einem Oberflächenbereich auch eine Kontaktschicht aufweisen. Die Kontaktschicht und das n-InP-Substrat werden dann metallisiert. Eine optische Mode wird in den in der lichtemittierenden Schicht optional vorhandenen Wellenleiterschichten und der Abdeckschicht geführt. Ein Teil der Mode kann sich jedoch auch in den umgebenden Schichten befinden.

In einem weiteren Schritt werden nun die soeben geformten horizontalen Justiermarken sowie weitere vertikale Justiermarken, beispielsweise mittels eines Nassätzprozesses freigelegt. Durch Masken auf der Abdeckungsschicht können die zu ätzenden Bereiche genau definiert werden. Ferner ermöglicht der Nassätzprozess eine selektive Ätzung der Abdeckungsschicht wodurch die Abdeckungsschicht selektiv bis auf die Begrenzungsschicht geätzt werden kann. Dass die vertikalen Justierungsmarken bzw. vertikalen Aufstandsflächen beabstandet von den Lichtein- bzw. Lichtaustrittskanten angeordnet werden, ermöglicht das nachträgliche Beschichten der Lichtein- bzw. Lichtaustrittskanten bzw. der Facetten, ohne dass sich das Beschichtungsmaterial auf den soeben freigelegten vertikalen Aufstandsflächen ablagert. Somit wird die Genauigkeit der Justierung der Halbleiterlichtquelle durch das Abscheiden der Beschichtung nicht beeinträchtigt.

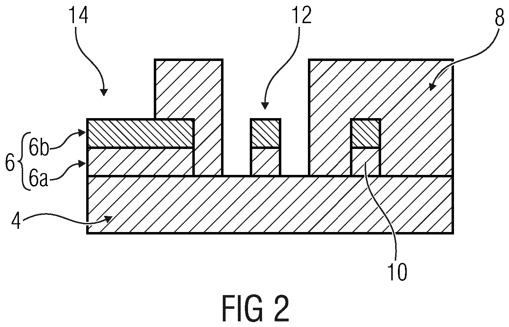

Fig. 2 zeigt eine schematische Darstellung einer Halbleiterlichtquelle, die durch das Verfahren aus Fig. 1 hergestellt werden kann. Die Halbleiterlichtquelle 2 weist ein Substrat 4, eine oberhalb des Substrats angeordnete strukturierte Schichtfolge 6 sowie eine Abdeckungsschicht 8 auf. Die strukturierte Schichtfolge 6 weist eine lichtemittierende Schicht 6a und eine oberhalb der lichtemittierenden Schicht 6a angeordnete Begrenzungsschicht 6b auf. Die lichtemittierende Schicht weist beispielsweise multiple quantum wells (dt.: multiple Quantentöpfe) auf, wobei die lichtemittierende Schicht angrenzend bzw. neben der Wellenleiterschicht 6b angeordnet ist. Die Wellenleiterschicht kann p- bzw. n-dotiert sein. Die strukturierte Schichtfolge weist einen lichtemittierenden Streifen 10 zur Definition der Halbleiterlichtquelle sowie einen sich dazu parallel erstreckenden Justierungsstreifen 12 auf. Der Justierungsstreifen kann durch eine einfache Aussparung in der Schichtfolge (z.B. eine Nut), oder durch zwei parallel verlaufende Gräben in der Schichtfolge (z.B. eine Feder) realisiert sein.

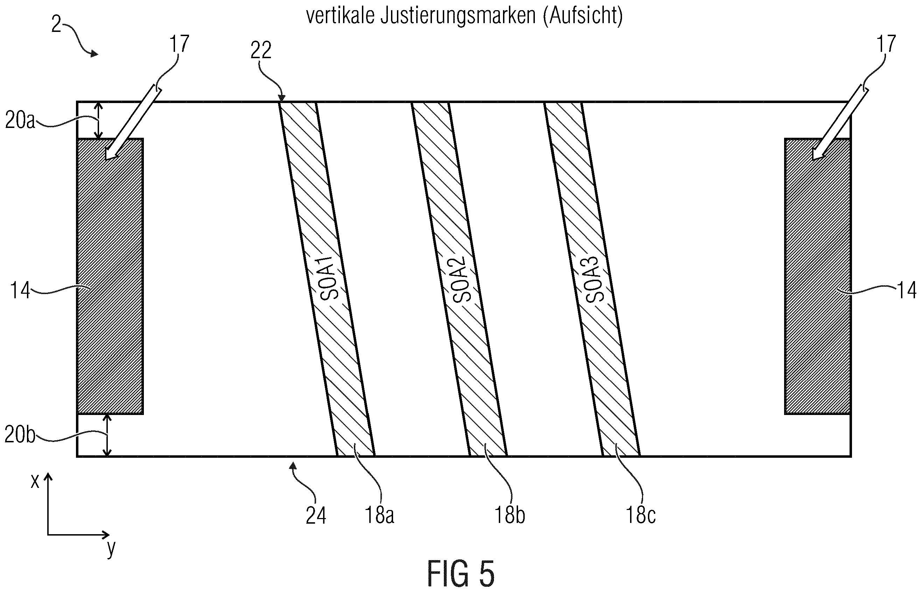

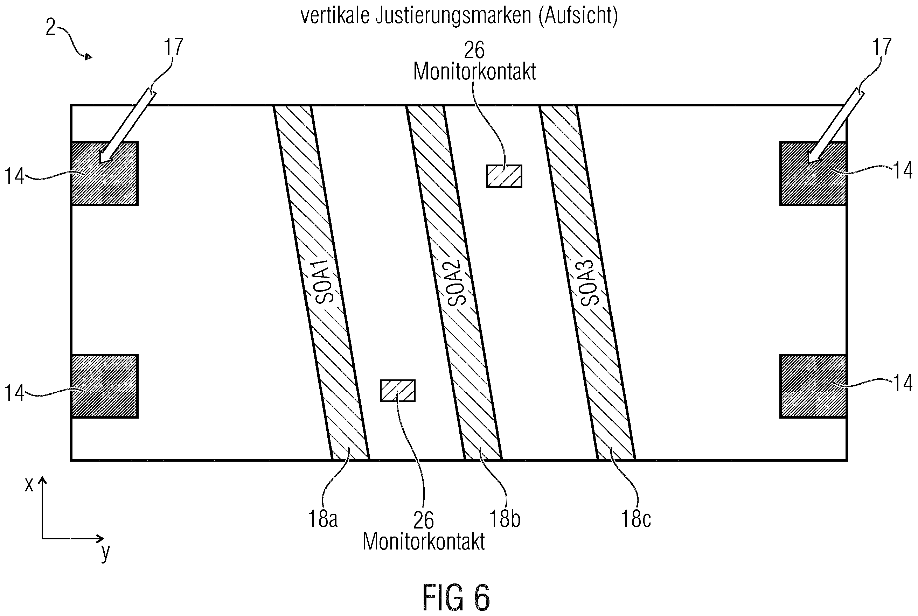

Auf der strukturierten Schichtfolge ist ferner die Abdeckungsschicht 8 angeordnet, die in einem Teil der strukturierten Schichtfolge 6 geöffnet ist, um den Justierungsstreifen 12 und einen Bereich der Schichtfolge außerhalb der lichtemittierenden Streifen 10 freizulegen. In einer Profilansicht der Abdeckungsschicht ist an den Stellen, an denen die Abdeckungsschicht geöffnet ist, ein Graben bzw. ein Loch zu sehen. Der geöffnet Teil der Abdeckungsschicht, der die vertikale Justierungsmarke 14 freilegt, ist beabstandet von einer Lichteintrittskante oder einer Lichtaustrittskante angeordnet, die sich an einer bzw. beiden Kopf- oder Stirnseiten des lichtemittierenden Streifens befindet. Dies ist in dem hier gezeigten Querschnitt der Halbleiterlichtquelle nicht dargestellt, wird jedoch beispielsweise in der Aufsicht in Fig. 5 oder 6 gezeigt. Gemäß Ausführungsbeispielen wird der Bereich über der vertikalen Justierungsmarke 14 selektiv zur Begrenzungsschicht entfernt, so dass ungeachtet von Ungenauigkeiten im Entfernungsprozess, beispielsweise einem Ätzvorgang, auf der Oberfläche von der Begrenzungsschicht eine definierte vertikale Aufstandsfläche bzw. Justierungsmarke entsteht. Der Cladding Layer kann einen geringeren Brechungsindex aufweisen als lichtemittierende Schicht.

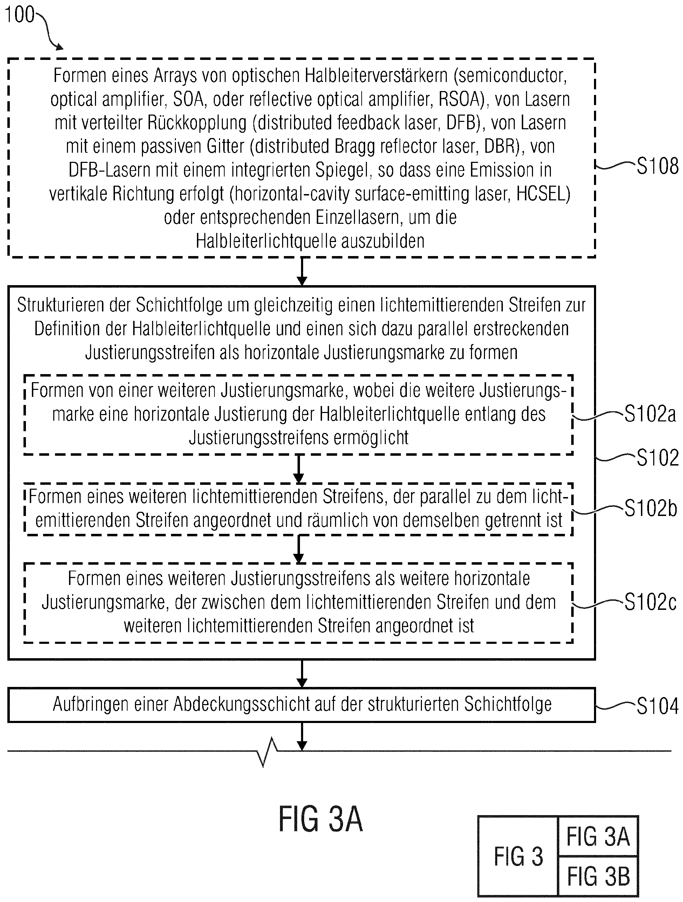

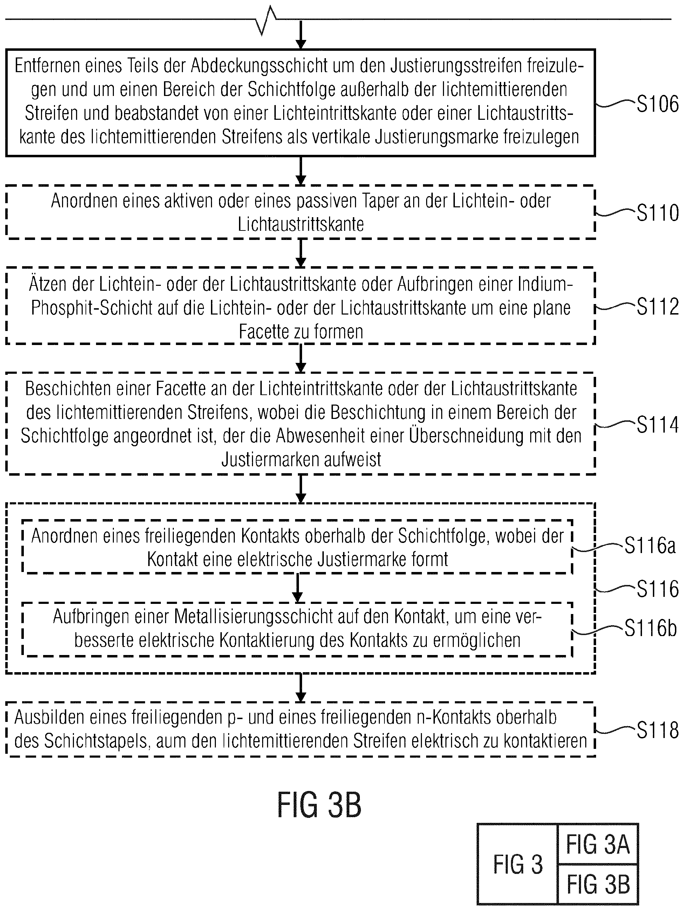

Fig. 3 zeigt ein Flussdiagramm des Verfahrens 100 mit weiteren, optionalen Schritten zur Herstellung der Halbleiterlichtquelle. Es ist anzumerken, dass ebenso wie in Fig. 1 und allgemein jede Beschreibung der Verfahrensschritte, eine Reihenfolge der Schritte bzw. ein Ablauf des Verfahrens nicht auf die in Fig. 1 bzw. Fig. 3 dargestellte bzw. beschriebene Reihenfolge beschränkt ist. Diese Figuren zeigen vielmehr ein mögliches Ausführungsbeispiel, wobei sich weitere Ausführungsbeispiele beispielsweise in der Verwendung der optionalen Schritte sowie in der Anwendung der Reihenfolge der Schritte unterscheiden können. Jede technisch realisierbare Reihenfolge der Schritte kann als ein mögliches Ausführungsbeispiel angesehen werden.

Fig. 3 zeigt in Ergänzung zu Fig. 1 einen Schritt S108 in dem ein Array von optischen Halbleiterverstärkern (semiconductor, optical amplifier, SOA, oder reflective optical amplifier, RSOA), von Lasern mit verteilter Rückkopplung (distributed feedback laser, DFB), von Lasern mit einem passiven Gitter (distributed Bragg reflector laser, DBR), von DFB-Lasern mit einem integrierten Spiegel, so dass eine Emission in vertikale Richtung erfolgt (horizontal-cavity surface-emitting laser, HCSEL) oder entsprechenden Einzellasern geformt werden, um die Halbleiterlichtquelle auszubilden. Die Aufzählung ist nicht als abschließend anzusehen und soll ferner nur typische Ausführungsformen der Halbleiterlichtquelle zeigen. Ferner kann dieser Schritt S108 als Handlungsanweisung für einen Fachmann angesehen werden, eine beliebige Halbleiterlichtquelle, die die vorgenannten Halbleiterlichtquellen und auch jede weitere mögliche Halbleiterlichtquelle umfasst, zu erzeugen und die für das Verfahren 100 spezifischen Verfahrensschritte in das bekannte Verfahren integriert.

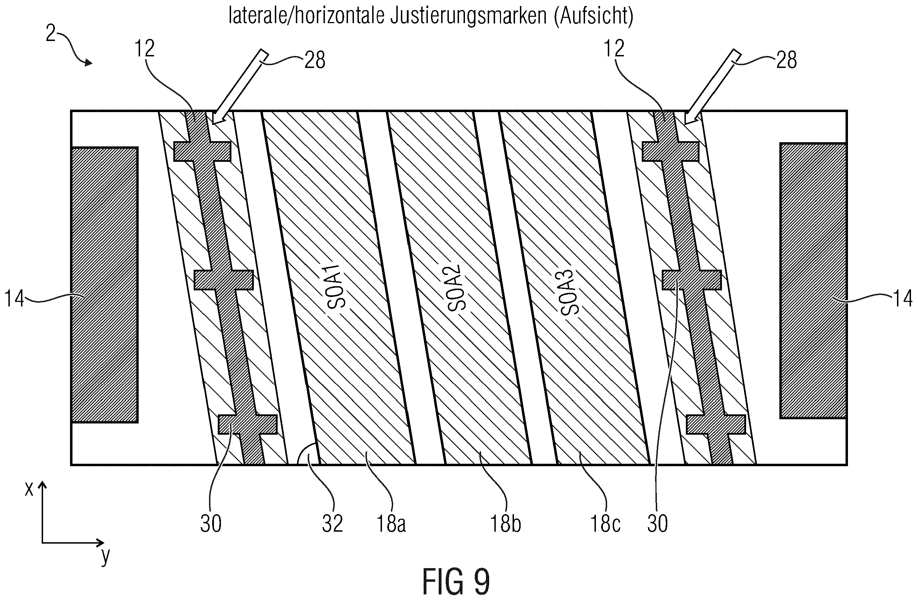

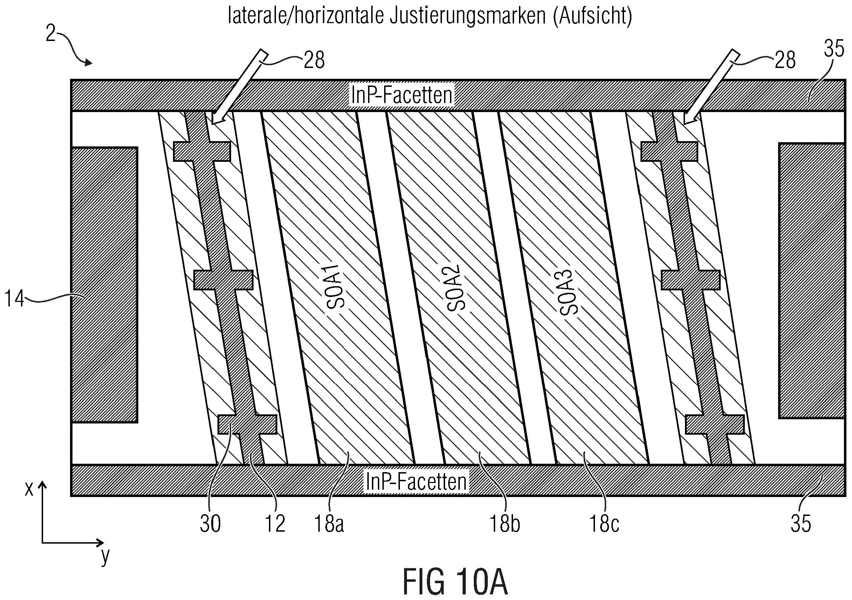

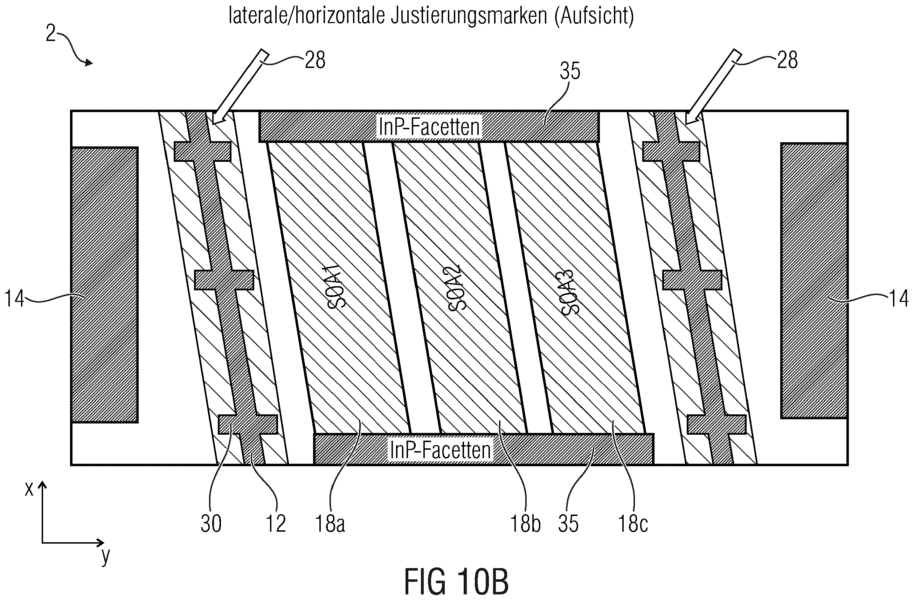

So zeigt der Schritt S102 das Strukturieren der Schichtfolge. Das Strukturieren S102 des lichtemittierenden Streifen 10 kann die Justierungsstreifen 12 in einem Winkel 32 größer oder kleiner 90° zu der Lichtein- oder Lichtaustrittskante 22, 24 formen. Gemäß Ausführungsbeispielen weist der Schritt S102 optional die Unterschritte S102a, S102b oder S102c auf. In Schritt S102a kann eine weitere Justierungsmarke geformt werden, wobei die weitere Justierungsmarke eine horizontale Justierung der Halbleiterlichtquelle entlang des Justierungsstreifens ermöglicht. Eine mögliche Ausgestaltung dieser weiteren Justierungsmarken wird anhand der Fig. 9 und 10 detaillierter beschrieben. Unabhängig von Schritt S102a, kann der Schritt S102b ausgeführt werden, indem ein weiterer lichtemittierender Streifen geformt wird, der parallel zu dem lichtemittierenden Streifen angeordnet und räumlich von demselben getrennt ist. Somit kann eine Array-Struktur geformt werden, die beispielsweise die in den folgenden Figuren gezeigten drei lichtemittierenden Streifen, z.B. einzelne Laser, optische Halbleiterverstärker oder lichtemittierende Dioden (LED) umfasst. Wird die Halbleiterlichtquelle in der Array-Struktur geformt, d.h. dass das Verfahren 100 mit dem optionalen Schritt S102b ausgeführt wird, kann ein weiterer Justierungsstreifen als weitere horizontale Justierungsmarke zwischen dem lichtemittierenden Streifen und den weiteren lichtemittierenden Streifen in einem Schritt 102c geformt werden.

Weitere Justierungsstreifen zwischen den Array-Strukturen können die Genauigkeit der Positionierung der Halbleiterlichtquelle in der Halbleitervorrichtung erhöhen. Analog hierzu kann auch der Schritt S106 angepasst werden, indem zwischen den Array-Strukturen bzw. zwischen dem Justierungsstreifen und dem weiteren Justierungsstreifen eine weitere vertikale Justierungsmarke angeordnet wird. Diese kann z.B. ein Durchbiegen der Halbleiterlichtquelle in der Mitte verhindern, so dass die Halbleiterlichtquelle nicht nur in einem Außenbereich der Halbleiterlichtquelle in vertikaler Richtung exakt positioniert ist, sondern durchgehend über die gesamte Fläche eine exakte Positionierung aufweist.

Weiterhin kann das Verfahren 100 einen Schritt S110 mit Anordnen eines aktiven oder eines passiven Tapers an der Lichtein- oder Lichtaustrittskante aufweisen. Der aktive oder passive Taper kann eine Lichtstreuung bzw. Lichtformung des an der Lichtaustrittskante austretenden Lichts vornehmen, so dass mittels des Tapers z.B. Lichtwellenleiter unterschiedlichen Durchmessers miteinander verbunden werden können. Ferner kann in einem Schritt S112 die Lichtein- oder Lichtaustrittskante geätzt oder durch Aufbringen einer Indium-Phosphit-Schicht auf die Lichtein- oder die Lichtaustrittskante eine plane Facette geformt werden. Die Facetten spielen insbesondere bei Lasern und bei optischen Verstärkern eine wichtige Rolle, um beispielsweise beim Laser nur das Licht einer bestimmten Resonanzwellenlänge zu emittieren und beim optischen Verstärker (SOA) eine Reflektion an den Facetten zu minimieren, um Rückkopplungseffekte zu vermeiden. Daher kann in einem Schritt S114 die Facette an der Lichteintrittskante oder der Lichtaustrittskante des lichtemittierenden Streifens beschichtet werden, wobei die Beschichtung in einem Bereich der Schichtfolge angeordnet ist, der die Abwesenheit einer Überschneidung mit den Justiermarken aufweist. In anderen Worten könnte die Beschichtung die vertikale Justierung der Halbleiterlichtquelle in der Halbleitervorrichtung beeinflussen, indem die Beschichtung auch auf die Aufstandsflächen für die vertikale Justierung aufgebracht wird und somit eine exakte Positionierung nicht mehr möglich ist.

Gemäß weiteren Ausführungsbeispielen kann das Verfahren 100 einen Schritt S116 aufweisen, der wiederum die Schritte S116a und S116b umfassen kann. In dem Schritt S116a kann ein freiliegender Kontakt oberhalb der Schichtfolge angeordnet werden, wobei der Kontakt eine elektrische Justiermarke formt. Um z.B. eine definierte Kontaktfläche zu schaffen und/oder eine verbesserte elektrische Kontaktierung des Kontakts zu ermöglichen, kann in einem Schritt S116b eine Metallisierungsschicht auf den Kontakt aufgebracht werden. Gemäß weiteren Ausführungsbeispielen kann in einem Schritt S118 ein freiliegender p- und/oder ein freiliegender n-Kontakt oberhalb des Schichtstapels ausgebildet werden, um den lichtemittierenden Streifen elektrisch zu kontaktieren. Dies ist vorteilhaft, da somit die Halbleitervorrichtung die vollständige elektrische Kontaktierung der Halbleiterlichtquelle übernehmen kann, ohne dass dieselbe eine externe Spannungsversorgung benötigt.

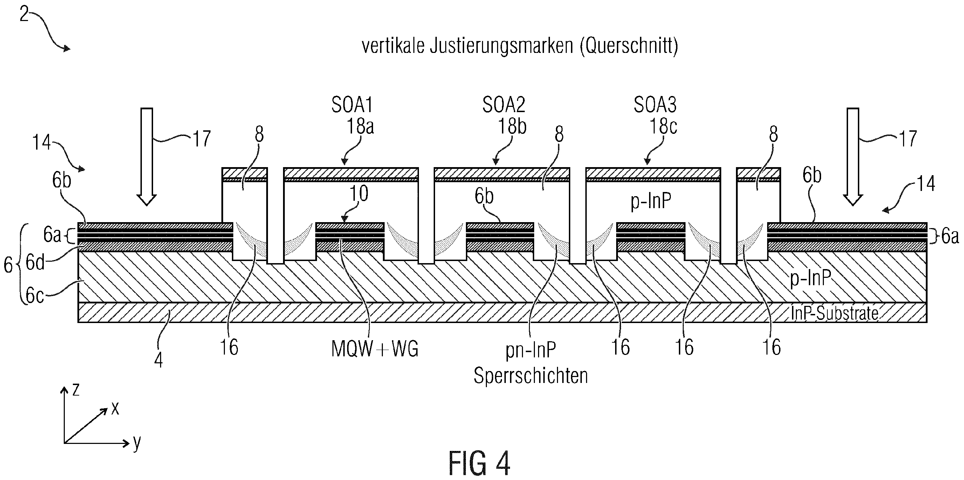

Fig. 4 zeigt eine schematische Darstellung einer Halbleiterlichtquelle gemäß einem Ausführungsbeispiel, die mit dem Verfahren 100 hergestellt werden kann. Die Halbleiterlichtquelle weist die bereits in Fig. 2 beschriebenen Merkmale auf: Das Substrat 4, die Schichtfolge 6, die die lichtemittierende Schicht 6a sowie die Begrenzungsschicht 6b aufweist, die Abdeckungsschicht 8 sowie die vertikale Justierungsmarke 14 in einem Bereich, in dem die Schichtfolge 6 von der Abdeckungsschicht 8 freigelegt ist. Die Schichtfolge 6 kann ferner weitere Schichten, wie z.B. eine n-dotierte Indium-Phosphitschicht 6c und einen weiteren Lichtwellenleiter 6d unterhalb der lichtemittierenden Schicht aufweisen. Somit kann die lichtemittierende Schicht in die Wellenleiterschichten 6b und 6d eingebettet sein. In anderen Worten umgeben die Wellenleiterschichten 6b und 6d die lichtemittierende Schicht 6a. Die Abdeckungsschicht 8 kann ferner p-dotiertes Indium Phosphit (p-InP) sowie darüber liegende Schutzschichten oder Kontakte aufweisen. Ferner können in der Abdeckschicht pn-Übergänge ausgebildet werden, die Sperrschichten 16 formen, um beispielsweise den Fluss von Ladungsträgern vorbei am lichtemittierenden Streifen, der auch als aktive Zonen bezeichnet wird, zu verhindern. Ferner ist anzumerken, dass allgemein an Stelle oder ergänzend von dem beispielhaft genannten Indium Phosphit (InP) in allen Bereichen der Halbleiterlichtquelle auch andere Materialien beispielsweise andere III-V Halbleiter, wie z.B. Gallium Arsenit (GaAs) verwendet werden können.

Fig. 4 zeigt im Querschnitt die vertikalen Justiermarken 14, die durch Entfernen, beispielsweise selektives (nasschemisches) Ätzen der Abdeckungsschicht 8 auf die Begrenzungsschicht 6 erzeugt werden. Gemäß dem in Fig. 4 gezeigten Ausführungsbeispiel formen die Bereiche 18a, 18b und 18c drei optische Halbleiterverstärker (SOA1, SOA2 und SOA3) ein Array von optischen Halbleiterverstärkern. Die Bereiche 18a, 18b und 18c umfassen jeweils zumindest einen lichtemittierenden Streifen 10.

Fig. 5 zeigt eine, zur Querschnittsansicht aus Fig. 4 korrespondierende Aufsicht auf die Halbleiterlichtquelle gemäß einem Ausführungsbeispiel. Ferner ist in Fig. 5 dargestellt, dass die vertikalen Justierungsmarken 14 in einem Abstand 20a, 20b beabstandet von einer Lichtein- bzw. Lichtaustrittskante 22, 24 angeordnet sind. Die Pfeile 17, die bereits in Fig. 4 dargestellt sind, zeigen die gemeinsamen vertikalen Justierungsmarken, in Aufsicht sowie in einem Querschnitt an.

Die Lichtein- bzw. Lichtaustrittskante 22,24 ist auf die gesamte Kante der Halbleiterlichtquelle bezogen, an der das Licht in die Halbleiterlichtquelle hineintritt bzw. aus der das Licht aus der Halbleiterlichtquelle hinaustritt. Somit kann das Entfernen S106 den Justierungsstreifen beabstandet von einer Ebene, in der die Lichteintrittskante oder die Lichtaustrittskante liegt, als vertikale Justierungsmarke freilegen. In wieder anderen Worten kann das Entfernen S106 den Justierungsstreifen beabstandet von einer Facette des lichtemittierenden Streifens als vertikale Justierungsmarke freilegen. Die Lichteintrittskannte und/oder die Lichtaustrittskante bzw. die Facette kann mit einem Beschichtungsmaterial beschichtet sein. Das Beschichten der Lichteintrittskante oder der Lichtaustrittskante mit dem Beschichtungsmaterial kann nach dem Freilegen der vertikalen Justierungsmarke erfolgen, da durch die Beabstandung der vertikalen Justierungsmarke von der zu beschichtenden Fläche, d.h. der Lichteintrittskante und/oder der Lichtaustrittskante bzw. der Facette, eine Ablagerung des Beschichtungsmaterials auf der vertikalen Justierungsmarke verhindert wird. Somit bleibt die exakte Positionierung der vertikalen Justierungsmarke erhalten. Die Facette kann an der gesamten Kante der Halbleiterlichtquelle (s. Fig. 10a) oder nur in einem begrenzten Bereich des lichtemittierenden Streifens (s. Fig. 10b) beschichtet werden. Ferner kann die vertikale Justierungsmarke auch beabstandet von der horizontalen Justierungsmarke angeordnet sein.

Die gezeigten Halbleiterlichtquellen, z.B. Buried-Heterostructure SOA- und Laser-Arrays unterscheidet sich in wesentlichen Punkten von den bisher bekannten Varianten.

Vertikale Aufstandsflächen 14 werden präzise mittels nasschemischer Ätzung auf den oberseitigen Wellenleiter 6b der aktiven Laserschicht geätzt. Entsprechende Flächen werden links und rechts der Laserstreifen 10 eines Arrays, oder ggfs. eines einzelnen Laserstreifens realisiert (Vgl Fig. 4 und 5).

Diese Flächen sollen im Gegensatz zu bekannten Varianten nicht in den Ecken des Chips, sondern jeweils nur in der Mitte des Chips realisiert werden.

Durch die nasschemische Ätzung kann selektiv auf die oberseitige Wellenleiterschicht geätzt werden, so dass man eine vertikale Genauigkeit von wenigen nm erreichen kann. Durch die Anordnung dieser Flächen nur in der Mitte des Chips verhindert man effektiv eine störende Bedeckung der Flächen bei der Facettenbeschichtung (Overspill). Eine solche Facettenbeschichtung ist bei allen SOA- und Laser-Arrays erforderlich. Die aufgebrachten Schichtdicken betragen 0.5...2µm, so dass eine präzise vertikale Justierung dann nicht mehr möglich ist.

Diese vertikalen Aufstandsflächen können z.B. auch jeweils in zwei separate Aufstandsflächen getrennt werden (Fig. 6).

Fig. 6 zeigt eine Aufsicht auf die Halbleiterlichtquelle 2 gemäß einem Ausführungsbeispiel, das sich in zwei Merkmalen von dem Ausführungsbeispiel aus Fig. 5 unterscheidet. Ein Merkmal ist die Aufteilung der in Fig. 5 seitlich angeordneten vertikalen Justierungsmarken in beispielsweise zwei Justierungsmarken für jede Seite aufzuteilen. Weitere Justierungsmarken, z.B. in Form von parallelen Schlitzen oder eines Rasters sind ebenfalls möglich.

Ferner zeigt Fig. 6 die Anordnung von Monitorkontakten 26 an der Oberseite der Halbleiterlichtquelle. Die Monitorkontakte können wie dargestellt zwischen den Arraystrukturen der einzelnen lichtemittierenden Strukturen angeordnet sein, sind jedoch nicht auf diese Positionen beschränkt. Wird die Halbleiterlichtquelle mit der elektrischen Justierungsmarke in die Vorrichtung, die die Halbleiterlichtquelle aufnimmt eingesetzt, kann mittels eines korrespondierenden Kontakts an der Vorrichtung, der den freiliegenden Kontakt oberhalb der Schichtfolge kontaktiert, über ein weiteres an einer beliebigen Stelle der Halbleiterlichtquelle sowie gegenüberliegend an der Halbleitervorrichtung angeordnetes Kontaktpaar ein Stromfluss erzeugt werden, der Aufschluss über die korrekte Justierung der Halbleiterlichtquelle bietet. In anderen Worten sind dafür an der Halbleiterlichtquelle zumindest zwei freiliegende Kontakte vorteilhaft, wobei zumindest einer der beiden freiliegenden Kontakte oberhalb der Schichtfolge angeordnet ist und eine elektrische Justiermarke formt. Somit wird, wenn die Kontakte an der Halbleiterlichtquelle nicht deckungsgleich mit den zugehörigen Kontakten der Halbleitervorrichtung sind, ein höherer Widerstand erzeugt, der bei einer bekannten angelegten Spannung zu einer Reduzierung des Stromflusses durch die Halbleiterlichtquelle führt und somit ein Maß für die Güte der Positionsgenauigkeit bietet.

Die vertikale Justage ist in der Regel für größere Chip-Dimensionen eine Herausforderung, da 'smiling' Effekte, Verkippungen o.ä. dazu führen können, dass die Z-Position nur an ausgewählten Punkten mit der Zielposition übereinstimmt. Um die vertikale Lage für jedes Element des Arrays zu kontrollieren wird vorgeschlagen, die mechanische Kontaktierung durch elektrische Kontaktgebung zu ergänzen. Z.B. lässt sich im Fall vom leitfähigem Substrat (wie z.B. n-InP) der Stromfluss über einen elektrischen Kontakt am Auflagepunkt der Gegenseite messen und die Qualität der Montage prüfen. Eine Anordnung solcher Monitorkontakte 26 kann auch zwischen den SOA/Laser Strukturen 10, 18a, 18b, 18c vorgesehen werden. Die Monitorkontakte stellen damit ein rein elektrisches Verfahren der aktiven Justage und Prozesskontrolle dar. Dies ist mit bisher bekannten Verfahren nicht möglich. Ggfs. kann hierzu eine nur wenige nm dicke Metallisierungsschicht aufgedampft werden, die einen guten elektrischen Kontakt sicherstellt.

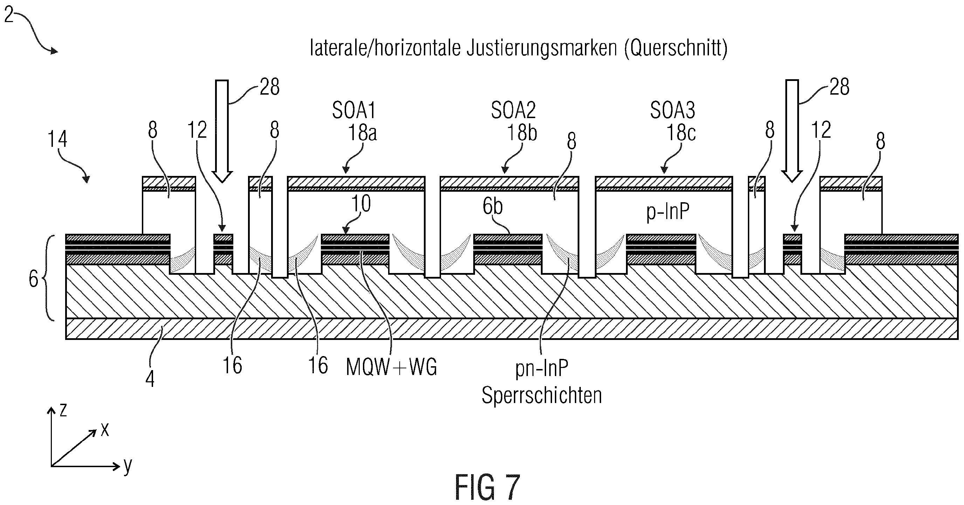

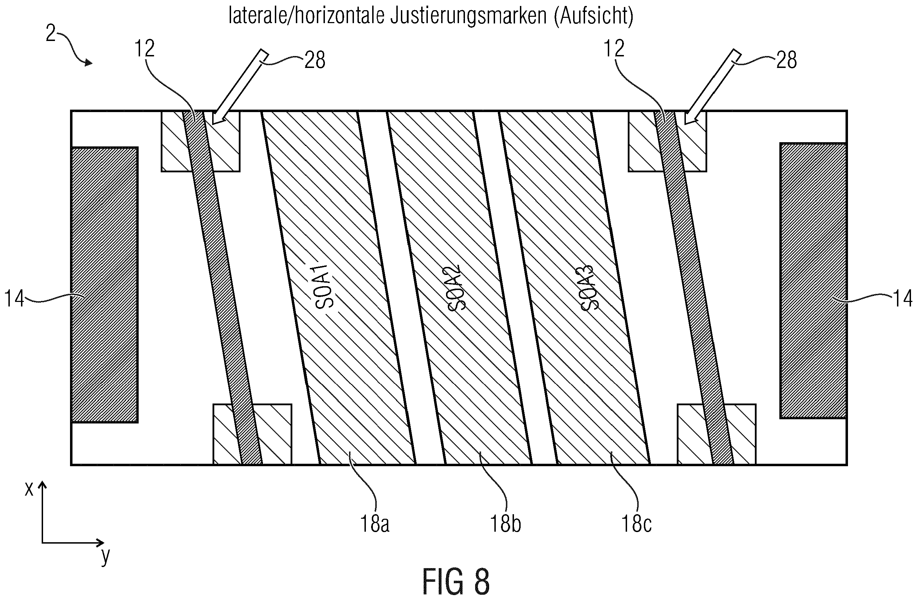

Die Figuren 7 bis 12 beschreiben Ausführungsbeispiele der Erfindung. In den Fig. 4-6 wurden bisher nur laterale und elektrische Justierungsmarken gezeigt. Fig. 7 zeigt einen schematischen Querschnitt der Halbleiterlichtquelle 2 gemäß einem Ausführungsbeispiel, das sich zu dem Ausführungsbeispiel aus Fig. 4 in der Anordnung von horizontalen Justiermarken 12 unterscheidet. Fig. 8 zeigt die Halbleiterlichtquelle aus Fig. 7 in einer Aufsicht.

Für die XY-Justierung werden präzise horizontale Justiermarken verwendet, die im selben Herstellungsschritt wie die Laserstreifen hergestellt werden, so dass Lithographieungenauigkeiten prinzipiell verhindert werden.

Es werden parallel zum Laserstreifen zusätzliche Streifen links und rechts realisiert. Diese Streifen werden in einem der letzten Prozessschritte bei der Herstellung der Laser nasschemisch freigelegt und sind dann als Justiermarken (von oben sichtbar) verwendbar (Vgl. Fig. 7 und 8).

Ein wesentlicher weiterer Vorteil dieser Justiermarken ist, dass sie auch im Fall von in Längsrichtung an unterschiedlichen Positionen gespaltenen SOA- und Laser-Arrays eingesetzt werden können und jeweils eine präzise passive Justage im sub-µm Bereich ermöglichen.

Technologisch unvermeidbare Spaltungenauigkeiten in der Größenordnung von +/-5...10µm spielen hier keine Rolle, da die entsprechenden Justiermarken dabei ebenfalls betroffen sind. Die exakte Position der Laseraustrittsfacetten ist in jedem Fall genau definiert, eine präzise Justage damit gewährleistet. Dies gilt für beide Facetten.

Vorteilhaft ist weiterhin, dass diese lateralen Justiermarken und damit die genaue Lage der aktiven Schicht nicht nur in der Aufsicht, sondern auch in der Facettenansicht erfasst werden können. Dies ist mit bisher bekannten Justiermarken nicht möglich und erlaubt die 3-dimensionale Informationserfassung.

Die durch diese Justiermarken zusätzlich benötigte Chipfläche fällt bei SOA- oder Laser-Arrays nicht ins Gewicht, so dass sich die Herstellungskosten dieser Chips nicht oder zumindest nicht wesentlich ändern.

Fig. 9 zeigt das Ausführungsbeispiel aus Fig. 8 mit weiteren Justierungsmarken 30, die eine Justierung der Halbleiterlichtquelle entlang des Justierungsstreifens 12 ermöglicht. Die weiteren Justierungsmarken 30 können, wie in Fig. 9 dargestellt, mit dem Justierungsstreifen 12 mechanisch verbunden sein, wodurch dieselben einen vergleichsweise geringen Platzbedarf haben. Ferner können die weiteren Justierungsmarken 30 auch in einem weiteren Bereich der Halbleiterlichtquelle abseits der Justierungsstreifen angeordnet sein. Da die Justierungstreifen 12 bzw. die horizontalen Justierungsmarken und die weiteren Justierungsmarken 30 bis auf den Wellenleiter, also die Begrenzungsschicht 6b geätzt werden und somit auch die gleiche Höhe der vertikalen Justiermarken 14 aufweisen, können diese auch als weitere vertikale Justiermarke verwendet werden. In anderen Worten können vertikale Aufstandsflächen 12 auch längs der gesamten Struktur realisiert werden und gegebenenfalls zusätzliche Strukturen 30 zur Orientierung in X-Richtung enthalten. (Siehe Fig. 9).

Diese vertikalen Aufstandsflächen auf den horizontalen Justierungsmarken 12, 30 können auch für SOA- oder Laser-Arrays mit InP-Facetten (ohne aktive Schicht im Facettenbereich) eingesetzt werden, wobei Fig. 10a und 10b zwei mögliche Ausführungsformen zeigen. Fig. 10a und Fig. 10b zeigen beide das Ausführungsbeispiel der Halbleiterlichtquelle aus Fig. 9 mit InP-Facetten an den Lichtein- bzw. Lichtaustrittskanten. In Fig. 10a ist die InP-Facette 35 über eine gesamte Breite der Halbleiterlichtquelle ausgedehnt, wohingegen in Fig. 10b die InP-Facette 35 auf den Bereich der aktiven Schichten, d.h. der lichtemittierenden Streifen beschränkt ist.

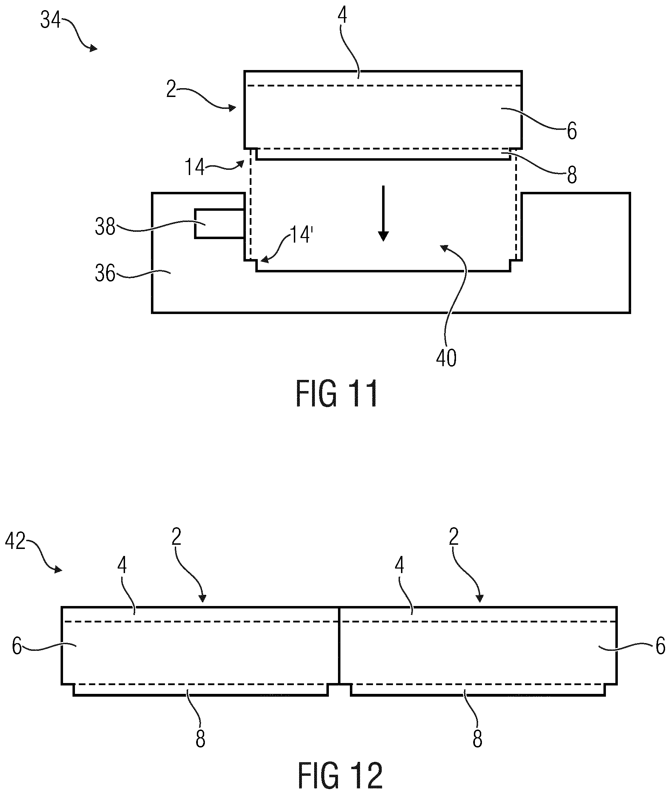

Fig. 11 zeigt eine Halbleitervorrichtung 34 mit einem Substrat 36 und einer optischen Einheit 38, wobei das Substrat 36 eine Ausnehmung 40 aufweist, die ausgebildet ist, die Halbleiterlichtquelle 2 oder eine Kaskade der Halbleiterlichtquelle, die in Fig. 12 gezeigt ist, derart aufzunehmen, dass die Halbleiterlichtquelle 2 mit der bzw. auf die optische Einheit 38 ausgerichtet ist. Die optische Einheit kann beispielsweise ein in Silizium oder ein anderen (Halbleiter-) Material strukturierter Wellenleiter oder ein optisches Bauelement sein. In dem in Fig. 11 gezeigten Ausführungsbeispiel ist die Halbleiterlichtquelle 2 vorteilhafterweise ein Laser oder eine LED, da nur eine optische Einheit 38 zum Empfang des ausgesendeten Lichts vorgesehen ist. Ist die Halbleiterlichtquelle 2 ein optischer Halbleiterverstärker (SOA) ist es vorteilhaft, eine weitere optische Einheit gegenüber der optischen Einheit 38 anzuordnen, um Licht in den optischen Halbleiterverstärker einzukoppeln, das in demselben verstärkt und an der optischen Einheit 38 ausgekoppelt wird.

Fig. 12 zeigt eine schematische Darstellung eines Querschnitts einer Kaskade von Halbleiterlichtquellen. Diese weist eine Mehrzahl, hier zwei, Halbleiterlichtquellen auf. So kann beispielsweise das emittierte Licht eines Lasers direkt in eine oder mehrere in Reihe bzw. hintereinander geschaltete optische Halbleiterverstärker eingekoppelt werden, um das Ausgangssignal des Lasers zu verstärken. Hierbei wird die Lichtaustrittskante einer Halbleiterlichtquelle mit der Lichteintrittskante einer nachfolgenden Halbleiterlichtquelle gekoppelt.

Weiter Ausführungsbeispiele der Erfindung beziehen sich auf folgende Beispiele:
1) Anstelle der InP-Facetten können auch geätzte Facetten verwendet werden
2) Anstelle der SOA-Arrays können auch RSOA-Arrays, DFB-Arrays, DBR-Arrays oder HCSEL-Arrays verwendet werden.
3) Kombinationen von SOAs und DFB-Lasern zu Arrays sind möglich
4) DFB-SOA-Anordnungen in Längsrichtung sind möglich
5) Versionen mit einseitig oder beidseitig integriertem aktiven oder passiven Taper sind möglich
6) Versionen mit in Längsrichtung getrennten elektrischen Kontakten sind möglich
7) Versionen mit oberseitigem p- und n-Kontakt für die einzelnen DFB-Laser oder SOAs sind möglich
8) Bei Bedarf können auch zusätzliche vertikale Aufstandsflächen und horizontale Justiermarken in der Mitte der Arrays angebracht werden.
9) Es können auch Einzelchips mit solchen vertikalen Aufstandsflächen und horizontalen Justiermarken hergestellt werden.
10) Es kann sich auch um Ridge-Waveguide-basierende SOA- oder Laser-Arrays handeln.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

### Referenzen

[1] T. Mitze, M. Schnarrenberger, L. Zimmermann, J. Bruns, F. Fidorra, J. Kreissl, K. Janiak, S. Fidorra, H. Heidrich, and K. Petermann, "Hybrid integration of III/V lasers on a silicon-on-insulator (SOI) optical board," in 2nd IEEE International Conference on Group IV Photonics, 2005, 2005, pp. 210-212.
[2] T. Mitze, M. Schnarrenberger, L. Zimmermann, J. Bruns, F. Fidorra, K. Janiak, J. Kreissl, S. Fidorra, H. Heidrich, and K. Petermann, "CWDM Transmitter Module Based on Hybrid Integration," IEEE Journal of Selected Topics in Quantum Electronics, vol. 12, no. 5, pp. 983-987, Sep. 2006.
[3] L. Stampoulidis, K. Vyrsokinos, C. Stamatiadis, H. Avramopoulos, L. Zimmermann, K. Voigt, Z. Sheng, D. Van Thourhout, J. Kreissl, L. Mörl, J. Bolten, T. Wahlbrink, F. Gomez-Agis, E. Tangdiongga, H. J. S. Dorren, A. Pagano, and E. Riccardi, "The BOOM project: a new generation of photonic routing subsystems using hybrid integration on silicon-on-insulator waveguide boards," 2010, vol. 7719, pp. 771909-771909-8.
[4] J. Kreissl, C. Bornholdt, T. Gaertner, L. Moerl, G. Przyrembel, and W. Rehbein, "1550 nm flip-chip compatible electroabsorption-modulated laser with 40 Gb/s modulation capability," in Compound Semiconductor Week (CSW/IPRM), 2011 and 23rd International Conference on Indium Phosphide and Related Materials, 2011, pp. 1-4.
[5] L. Zimmermann, G. B. Preve, T. Tekin, T. Rosin, and K. Landles, "Packaging and Assembly for Integrated Photonics #x2014;A Review of the ePIXpack Photonics Packaging Platform," IEEE Journal of Selected Topics in Quantum Electronics, vol. 17, no. 3, pp. 645-651, May 2011.
[6] L. Zimmermann, G. B. Preve, K. Voigt, G. Winzer, J. Kreissl, L. Moerl, C. Stamatiadis, L. Stampoulidis, and H. Avramopoulos, "High-precision flip-chip technology for alloptical wavelength conversion using SOI photonic circuit," in 2011 8th IEEE International Conference on Group IV Photonics (GFP), 2011, pp. 237-239.
[7] C. Stamatiadis, L. Stampoulidis, K. Vyrsokinos, I. Lazarou, D. Kalavrouziotis, L. Zimmermann, K. Voigt, G. B. Preve, L. Moerl, J. Kreissl, and H. Avramopoulos, "A hybrid photonic integrated wavelength converter on a silicon-on-insulator substrate," in Optical Fiber Communication Conference and Exposition (OFC/NFOEC), 2012 and the National Fiber Optic Engineers Conference, 2012, pp.1-3.

## Patentansprüche

1. Verfahren (100) zur Herstellung einer Halbleiterlichtquelle (2) mit einem Substrat (4), einer oberhalb des Substrats (4) angeordneten Schichtfolge (6), die eine lichtemittierende Schicht (6a) und eine oberhalb der lichtemittierenden Schicht angeordnete obere Begrenzungsschicht (6b) aufweist, einer horizontalen Justierungsmarke (12) und vertikalen Aufstandsflächen (14), mit folgenden Schritten:
Strukturieren (S102) der Schichtfolge (6), um gleichzeitig einen lichtemittierenden Streifen (10) zur Definition der Halbleiterlichtquelle und einen sich dazu parallel erstreckenden Justierungsstreifen (12) zu formen;
Aufbringen (S104) einer Abdeckungsschicht (8) auf der strukturierten Schichtfolge (6),
**gekennzeichnet durch**
gleichzeitiges Entfernen (S106) eines ersten Teils der Abdeckungsschicht (8), um den Justierungsstreifen als horizontale Justierungsmarke (12) freizulegen, und zweiter Teile der Abdeckungsschicht (8), um beidseitig des lichtemittierenden Streifens (10) Bereiche der Schichtfolge (6), die beabstandet von einer Lichteintrittskante (22) oder einer Lichtaustrittskante (24) der Halbleiterlichtquelle sind, als vertikale Aufstandsflächen (14) freizulegen.

2. Verfahren (100) gemäß Anspruch 1, mit Beschichten der Lichteintrittskante oder der Lichtaustrittskante mit einem Beschichtungsmaterial nach dem Freilegen der vertikalen Aufstandsflächen.

3. Verfahren (100) gemäß Anspruch 1 oder 2, wobei das Entfernen (S106) des Teils der Abdeckungsschicht (8) die Begrenzungsschicht (6b) freilegt.

4. Verfahren (100) gemäß einem der vorherigen Ansprüche, mit
Anordnen (S116a) eines freiliegenden Kontakts oberhalb der Schichtfolge, wobei der Kontakt eine elektrische Justiermarke formt, und
Aufbringen (S116b) einer Metallisierungsschicht auf den Kontakt (26), um eine verbesserte elektrische Kontaktierung des Kontakts (26) zu ermöglichen.

5. Verfahren (100) gemäß einem der vorherigen Ansprüche, wobei das Strukturieren (S102) der Schichtfolge (6) zum Formen der Justierungsstreifen (12) das Formen von einer weiteren Justierungsmarke (30) umfasst, wobei die weitere Justierungsmarke (30) eine Justierung der Halbleiterlichtquelle entlang des Justierungsstreifens ermöglicht.

6. Verfahren (100) gemäß einem der vorherigen Ansprüche, mit Ätzen (S112) der Lichtein- oder der Lichtaustrittskante (22, 24) oder Aufbringen (S114) einer Indium Phosphitschicht auf die Lichtein- oder die Lichtaustrittskante (22, 24), um eine plane Facette (35) zu formen.

7. Verfahren (100) gemäß einem der vorherigen Ansprüche, mit Formen (S108) eines Arrays von optischen Halbleiterverstärkern, von Lasern mit verteilter Rückkopplung, von Lasern mit einem passiven Gitter, von DFB-Lasern mit einem integrierten Spiegel, so dass eine Emission in vertikale Richtung erfolgt oder entsprechenden Einzellasern, um die Halbleiterlichtquelle auszubilden.

8. Verfahren (100) gemäß einem der vorherigen Ansprüche, wobei das Strukturieren (S102) des lichtemittierenden Streifen (10) und des Justierungsstreifen (12) dieselben in einem Winkel (32) größer oder kleiner 90° zu der Lichtein- oder Lichtaustrittskante (22, 24) formt.

9. Verfahren (100) gemäß einem der vorherigen Ansprüche, mit Anordnen (S110) eines aktiven oder eines passiven Taper an der Lichtein- oder Lichtaustrittskante (22, 24).

10. Verfahren (100) gemäß einem der vorherigen Ansprüche, mit Ausbilden (S118) eines freiliegenden p- und/oder eines freiliegenden n-Kontakts oberhalb des Schichtstapels (6),um den lichtemittierenden Streifen (10) elektrisch zu kontaktieren.

11. Verfahren (100) gemäß einem der vorherigen Ansprüche, wobei das Strukturieren (S102) einen weiteren lichtemittierenden Streifen formt, der parallel zu dem lichtemittierenden Streifen (10) angeordnet ist und räumlich von demselben getrennt ist, und
das Verfahren (100) ein Anordnen von weiteren vertikalen Aufstandsflächen oder horizontalen Justiermarken zwischen dem lichtemittierenden Streifen (10) und dem weiteren lichtemittierenden Streifen umfasst.

12. Halbleiterlichtquelle (2) mit folgenden Merkmalen:
einem Substrat (4), einer oberhalb des Substrats (4) angeordneten strukturierten Schichtfolge (6), die eine lichtemittierende Schicht (6a) und eine oberhalb der lichtemittierenden Schicht angeordnete obere Begrenzungsschicht (6b) aufweist, einer horizontalen Justierungsmarke (12) und vertikalen Aufstandsflächen (14),
wobei die strukturierte Schichtfolge (6) einen lichtemittierenden Streifen (10), der die Halbleiterlichtquelle (2) definiert und einen sich dazu parallel erstreckenden Justierungsstreifen aufweist;
einer Abdeckungsschicht (8) auf der strukturierten Schichtfolge (6);
wobei die Abdeckungsschicht (8) über einem ersten Teil der strukturierten Schichtfolge (6) geöffnet ist, so dass der Justierungsstreifen als horizontale Justierungsmarke (12) freigelegt ist,
**dadurch gekennzeichnet, dass**
die Abdeckungsschicht (8) über zweiten Teilen der strukturierten Schichtfolge (6) geöffnet ist, so dass beidseitig des lichtemittierenden Streifens (10) Bereiche der Schichtfolge (6), die beabstandet von einer Lichteintrittskante (22) oder einer Lichtaustrittskante (24) der Halbleiterlichtquelle angeordnet sind, als vertikale Aufstandsflächen (14) freigelegt sind.

13. Kaskade (42) von Halbleiterlichtquellen (2) mit einer Mehrzahl von Halbleiterlichtquellen gemäß Anspruch 12, wobei die Lichtaustrittskante einer Halbleiterlichtquelle mit der Lichteintrittskante einer nachfolgenden Halbleiterlichtquelle gekoppelt ist.

14. Kaskade (42) gemäß Anspruch 13, wobei ein Halbleiterlaser eine erste Halbleiterlichtquelle (2) der Kaskade (42) formt und zumindest ein weiterer Halbleiterverstärker eine weitere Halbleiterlichtquelle (2) der Kaskade (42) formt.

15. Halbleitervorrichtung (34) mit
einer Halbleiterlichtquelle (2) gemäß Anspruch 12 oder einer Kaskade von Halbleiterlichtquellen (2) gemäß Anspruch 13 oder 14,
einem Substrat (36), und
einer optischen Einheit (38),
wobei das Substrat (36) eine Ausnehmung (40) aufweist, die ausgebildet ist, die Halbleiterlichtquelle (2) die Kaskade von Halbleiterlichtquellen (2) derart aufzunehmen, dass die Halbleiterlichtquelle (2) mit der optischen Einheit (38) ausgerichtet ist.

## Claims

1. A method (100) for manufacturing a semiconductor light source (2) comprising a substrate (4), a layer sequence (6) arranged above the substrate (4) comprising a light-emitting layer (6a) and an upper boundary layer (6b) arranged above the light-emitting layer, a horizontal alignment mark (12) and vertical contact areas (14), comprising:
patterning (S102) the layer sequence (6) in order to simultaneously form a light-emitting stripe (10) for defining the semiconductor light source, and an alignment stripe (12) extending in parallel thereto;
applying (S104) a cover layer (8) onto the patterned layer sequence (6);
**characterized by**:
simultaneously removing (S106) a first part of the cover layer (8) in order to expose the alignment stripe as horizontal alignment mark (12), and second parts of the cover layer (8) to expose, on both sides of the light-emitting stripe (10), regions of the layer sequence (6) that are spaced apart from a light-entrance edge (22) or a light-exit edge (24) of the semiconductor light source, as vertical contact areas (14).

2. The method (100) in accordance with claim 1, comprising coating the light-entrance edge or the light-exit edge by a coating material after exposing the vertical contact areas.

3. The method (100) in accordance with claim 1 or 2, wherein removing (S106) the part of the cover layer (8) exposes the boundary layer (6b).

4. The method (100) in accordance with any of the preceding claims, comprising:
arranging (S116a) an exposed contact above the layer sequence, wherein the contact forms an electrical alignment mark, and
applying (S116b) a metallization layer on the contact (26) in order to allow improved electrical contacting of the contact (26).

5. The method (100) in accordance with any of the preceding claims, wherein patterning (S102) the layer sequence (6) to form the alignment stripes (12) comprises forming a further alignment mark (30), the further alignment mark (30) allowing alignment of the semiconductor light source along the alignment stripe.

6. The method (100) in accordance with any of the preceding claims, comprising etching (S112) the light-entrance or light-exit edge (22, 24) or applying (S114) an indium phosphide layer on the light-entrance or light-exit edge (22, 24) in order to form a planar facet (35).

7. The method (100) in accordance with any of the preceding claims, comprising forming (S108) an array of optical semiconductor amplifiers, passive grating lasers, DFB lasers comprising an integrated mirror so that there will be emission in the vertical direction or corresponding single lasers in order to form the semiconductor light source.

8. The method (100) in accordance with any of the preceding claims, wherein patterning (S102) the light-emitting stripe (10) and the alignment stripe (12) forms the same in an angle (32) greater or smaller than 90° relative to the light-entrance or light-exit edge (22, 24).

9. The method (100) in accordance with any of the preceding claims, comprising arranging (S110) an active or passive taper at the light-entrance or light-exit edge (22, 24).

10. The method (100) in accordance with any of the preceding claims, comprising forming (S118) an exposed p and/or an exposed n contact above the layer stack (6) in order to contact the light-emitting stripe (10) electrically.

11. The method (100) in accordance with any of the preceding claims, wherein patterning (S102) forms a further light-emitting stripe arranged in parallel to the light-emitting stripe (10) and spatially separated therefrom, and
the method (100) comprises arranging further vertical contact areas or horizontal alignment marks between the light-emitting stripe (10) and the further light-emitting stripe.

12. A semiconductor light source (2) comprising:
a substrate (4), a patterned layer sequence (6) arranged above the substrate (4) comprising a light-emitting layer (6a) and an upper boundary layer (6b) arranged above the light-emitting layer, a horizontal alignment mark (12) and vertical contact areas (14),
wherein the patterned layer sequence (6) comprises a light-emitting stripe (10) which defines the semiconductor light source (2), and an alignment stripe, extending in parallel thereto;
a cover layer (8) on the patterned layer sequence (6);
wherein the cover layer (8) is open over a first part of the patterned layer sequence (6) so that the alignment stripe is exposed as a horizontal alignment mark (12),
**characterized in that**
the cover layer (8) is open over second parts of the patterned layer sequence (6) so that, on both sides of the light-emitting stripe (10), regions of the layer sequence (6) arranged to be spaced apart from a light-entrance edge (22) or a light-exit edge (24) of the semiconductor light source, are exposed as vertical contact areas (14).

13. A cascade (42) of semiconductor light sources (2) comprising a plurality of semiconductor light sources in accordance with claim 12, wherein the light-exit edge of a semiconductor light source is coupled to the light-entrance edge of a subsequent semiconductor light source.

14. The cascade (42) in accordance with claim 13, wherein a semiconductor laser forms a first semiconductor light source (2) of the cascade (42) and at least one further semiconductor amplifier forms a further semiconductor light source (2) of the cascade (42).

15. A semiconductor device (34) comprising:
a semiconductor light source (2) in accordance with claim 12 or a cascade of semiconductor light sources (2) in accordance with claims 13 or 14,
a substrate (36), and
an optical unit (38),
the substrate (36) comprising a recess (40) configured to receive the semiconductor light source (2) or the cascade of semiconductor light sources (2) such that the semiconductor light source (2) is aligned with the optical unit (38).

## Revendications

1. Procédé (100) de fabrication d'une source de lumière à semi-conducteur (2) avec un substrat (4), une séquence de couches (6) disposée au-dessus du substrat (4) qui présente une couche électroluminescente (6a) et une couche de limitation supérieure (6b) disposée au-dessus de la couche électroluminescente, un repère d'ajustement horizontal (12) et des faces de contact verticales (14), aux étapes suivantes consistant à:
structurer (S102) la séquence de couches (6) pour former simultanément une bande électroluminescente (10) destinée à définir la source de lumière à semi-conducteur et une bande d'ajustement (12) s'étendant parallèlement à cette dernière;
appliquer (S104) une couche de recouvrement (8) sur la séquence de couches structurée (6),
**caractérisé par** le fait de
éliminer simultanément (S106) une première partie de la couche de recouvrement (8) pour exposer la bande d'ajustement comme repère d'ajustement horizontal (12), et des deuxièmes parties de la couche de recouvrement (8) pour exposer comme faces de contact verticales (14), de part et d'autre de la bande électroluminescente (10), des zones de la séquence de couches (6) qui sont distantes d'un bord d'entrée de lumière (22) ou d'un bord de sortie de lumière (24) de la source de lumière à semi-conducteur.

2. Procédé (100) selon la revendication 1, avec le fait de revêtir le bord d'entrée de lumière ou le bord de sortie de lumière d'un matériau de revêtement après l'exposition des faces de contact verticales.

3. Procédé (100) selon la revendication 1 ou 2, dans lequel l'élimination (S106) de la partie de la couche de recouvrement (8) expose la couche de limitation (6b).

4. Procédé (100) selon l'une des revendications précédentes, avec le fait de
disposer (S116a) un contact exposé au-dessus de la séquence de couches, où le contact constitue un repère d'ajustement électrique, et
appliquer (S116b) une couche de métallisation sur le contact (26) pour permettre une mise en contact électrique améliorée du contact (26).

5. Procédé (100) selon l'une des revendications précédentes, dans lequel la structuration (S102) de la séquence de couches (6) pour former les bandes d'ajustement (12) comporte le fait de former un autre repère d'ajustement (30), où l'autre repère d'ajustement (30) permet un ajustement de la source de lumière à semi-conducteur le long de la bande d'ajustement.

6. Procédé (100) selon l'une des revendications précédentes, avec le fait de graver (S112) le bord d'entrée ou de sortie de lumière (22, 24) ou d'appliquer (S114) une couche de phosphite d'indium sur le bord d'entrée ou de sortie de lumière (22, 24) pour former une facette plane (35).

7. Procédé (100) selon l'une des revendications précédentes, avec le fait de former (S108) un réseau d'amplificateurs optiques à semi-conducteur, de lasers à rétroaction distribuée, de lasers à grille passive, de lasers DFB avec un miroir intégré de sorte qu'une émission ait lieu dans une direction verticale, ou des lasers individuels correspondants pour former la source de lumière à semi-conducteur.

8. Procédé (100) selon l'une des revendications précédentes, dans lequel la structuration (S102) de la bande électroluminescente (10) et de la bande d'ajustement (12) forme ces dernières selon un angle (32) supérieur ou inférieur à 90° par rapport au bord d'entrée ou de sortie de lumière (22, 24).

9. Procédé (100) selon l'une des revendications précédentes, avec le fait de disposer (S110) un cône actif ou un cône passif sur le bord d'entrée ou de sortie de lumière (22, 24).

10. Procédé (100) selon l'une des revendications précédentes, avec le fait de former (S118) un contact p exposé et/ou un contact n exposé au-dessus de la pile de couches (6) pour mettre en contact électrique la bande électroluminescente (10).

11. Procédé (100) selon l'une des revendications précédentes, dans lequel
la structuration (S102) forme une autre bande électroluminescente qui est disposée parallèlement à la bande électroluminescente (10) et séparée spatialement de cette dernière, et
le procédé (100) comporte une disposition d'autres faces de contact verticales ou de repères d'ajustement horizontaux entre la bande électroluminescente (10) et l'autre bande électroluminescente.

12. Source de lumière à semi-conducteur (2), aux caractéristiques suivantes:
un substrat (4), une séquence de couches structurées (6) disposée au-dessus du substrat (4) qui présente une couche électroluminescente (6a) et une couche de limitation supérieure (6b) disposée au-dessus de la couche électroluminescente, un repère d'ajustement horizontal (12) et des faces de contact verticales (14),
dans laquelle la séquence de couches structurée (6) présente une bande électroluminescente (10) qui définit la source de lumière à semi-conducteur (2) et présente une bande d'ajustement s'étendant parallèlement à cette dernière;
une couche de recouvrement (8) sur la séquence de couches structurée (6);
dans laquelle la couche de recouvrement (8) est ouverte sur une première partie de la séquence de couches structurée (6), de sorte que la bande d'ajustement soit exposée comme repère d'ajustement horizontal (12),
**caractérisée par le fait que**
la couche de recouvrement (8) est ouverte sur des deuxièmes parties de la séquence de couches structurée (6), de sorte que soient exposées comme faces de contact verticales (14), de part et d'autre de la bande électroluminescente (10), des zones de la séquence de couches (6) qui sont disposées distantes d'un bord d'entrée de lumière (22) ou d'un bord de sortie de lumière (24) de la source de lumière à semi-conducteur.

13. Cascade (42) de sources de lumière à semi-conducteur (2) avec une pluralité de sources de lumière à semi-conducteur selon la revendication 12, dans laquelle le bord de sortie de lumière d'une source de lumière à semi-conducteur est couplé au bord d'entrée de lumière d'une source de lumière à semi-conducteur suivante.

14. Cascade (42) selon la revendication 13, dans laquelle un laser à semi-conducteur constitue une première source de lumière à semi-conducteur (2) de la cascade (42) et au moins un autre amplificateur à semi-conducteur constitue une autre source de lumière à semi-conducteur (2) de la cascade (42).

15. Dispositif à semi-conducteur (34) avec
une source de lumière à semi-conducteur (2) selon la revendication 12 ou une cascade de sources de lumière à semi-conducteur (2) selon la revendication 13 ou 14,
un substrat (36), et
une unité optique (38),
dans lequel le substrat (36) présente un évidement (40) qui est conçu pour recevoir la source de lumière à semi-conducteur (2) ou la cascade de sources de lumière à semi-conducteur (2) de sorte que la source de lumière à semi-conducteur (2) soit alignée sur l'unité optique (38).
